# EUROPEAN PATENT APPLICATION

(11) **EP 4 745 657 A1**
(43) Date of publication of application: **20.05.2026**
(21) Application number: 25165021.4
(22) Date of filing: 20.03.2025
(51) Int. Cl.: G02F 1/13357, H10H 20/856

(54) **LIGHT SOURCE MODULE**

(30) Priority: 18.11.2024 TW 113144263
(71) Applicant: Eosopto Technology Co., Ltd, Taichung City 408017 (TW)
(72) Inventor: CHEN, Ko-Yu, 407 Taichung City (TW); YANG, Wen-Hsun, 302058 Zhubei City, Hsinchu County (TW); LIU, Sheng-Tsung, 408017 Taichung City (TW); LIN, Tseng-Lien, 408017 Taichung City (TW)
(74) Representative: Becker, Eberhard

(57) **Abstract**

A light source module (10) including a circuit board (100), a light-emitting device (120), an encapsulation layer (140) and a plurality of microcavities (CV1, CV2, CV3) is provided. The light-emitting device (120) is disposed on a substrate surface (100s) of the circuit board (100), and is electrically connected to the circuit board (100). The encapsulation layer (140) directly covers the substrate surface (100s) and the light-emitting device (120), and has a first surface (140s1) connecting the substrate surface (100s). The plurality of microcavities (CV1, CV2, CV3) are embedded in the encapsulation layer (140). At least a part of the plurality of microcavities (CV1, CV2, CV3) are disposed adjacent to the first surface (140s1) and do not overlap with a light-emitting surface (120es) of the light-emitting device (120) along a normal direction (Z) of the substrate surface (100s).

## Description

### BACKGROUND

### Technical Field

The disclosure relates to an optical module, and in particular, relates to a light source module.

### Description of Related Art

With the increasing application of non-self-luminous displays such as liquid crystal displays, the design of the backlight modules also needs to be adjusted for different applications. In order to meet the needs of displaying a high dynamic range (HDR) and high contrast for panel products, the backlight modules are required to exhibit local dimming. Therefore, treating the direct-type backlight modules as the main light source structure has gradually become the mainstream of the market.

Since this type of backlight modules are expected to achieve a thinner thickness (for example, the optical distance is less than 10 mm), the light-emitting device is usually covered with an encapsulation layer having a reflective member or a reflective structure, so as to achieve a relatively uniform light-emitting effect on the light-emitting surface of a backlight module. However, some of the light emitted by the light-emitting device is prone to being reflected by the solder resist ink on the circuit board and cannot continue to be transmitted in the encapsulation body during its lateral transmission within the encapsulation layer, thereby reducing the light-guiding efficiency of the encapsulation layer.

### SUMMARY

The disclosure provides a light source module with improved light-guiding efficiency in its encapsulation layer.

The disclosure provides a light source module including a circuit board, a light-emitting device, an encapsulation layer and a plurality of microcavities. The light-emitting device is disposed on a substrate surface of the circuit board, and is electrically connected to the circuit board. The encapsulation layer directly covers the substrate surface and the light-emitting device, and has a first surface connecting the substrate surface. The plurality of microcavities are embedded in the encapsulation layer. At least a part of the plurality of microcavities are disposed adjacent to the first surface and do not overlap with a light-emitting surface of the light-emitting device along a normal direction of the substrate surface.

In an embodiment of the disclosure, the at least a part of the plurality of microcavities of the light source module include a plurality of first microcavities. The plurality of first microcavities are disposed adjacent to the first surface and are spaced apart along a direction parallel to the first surface to form a reflective unit. A plurality of the reflective units are spaced apart along the direction. A spacing between any two adjacent ones of the plurality of reflective units along the direction is greater than a spacing between any two adjacent ones of the plurality of first microcavities along the direction.

In an embodiment of the disclosure, the spacing between any two adjacent ones of the plurality of first microcavities of the light source module decreases or increases as a distance from the light-emitting device increases.

In an embodiment of the disclosure, any two adjacent ones of the plurality of first microcavities of the light source module are staggered from each other along the direction.

In an embodiment of the disclosure, the plurality of microcavities of the light source module further include a plurality of second microcavities disposed on one side of the plurality of first microcavities facing away from the first surface and spaced apart along the direction to form a refractive unit. In the normal direction of the substrate surface, a distance between the refractive unit and the first surface or a second surface is greater than or equal to a thickness of the refractive unit.

In an embodiment of the disclosure, a spacing between any two adjacent ones of the plurality of second microcavities of the light source module decreases or increases as a distance from the light-emitting device increases.

In an embodiment of the disclosure, any two adjacent ones of the plurality of second microcavities of the light source module are staggered from each other along the direction.

In an embodiment of the disclosure, in the normal direction of the substrate surface of the light source module, the refractive unit partially overlaps the reflective unit, and the refractive unit and the reflective unit are staggered from each other.

In an embodiment of the disclosure, the plurality of microcavities of the light source module further include a plurality of second microcavities disposed on one side of the light-emitting surface of the light-emitting device. In the normal direction of the substrate surface, a light modulating unit composed of the plurality of second microcavities overlaps the light-emitting surface.

In an embodiment of the disclosure, the plurality of second microcavities of the light source module are respectively arranged along a plurality of virtual planes parallel to the light-emitting surface. The plurality of virtual planes are spaced apart along a normal direction of the light-emitting surface. The number of the plurality of second microcavities arranged on each of the plurality of virtual planes increases or decreases as a distance from the light-emitting surface increases.

In an embodiment of the disclosure, two parts of the plurality of second microcavities of the light source module respectively arranged along any two adjacent ones of the plurality of virtual planes are staggered from each other in the normal direction of the light-emitting surface.

In an embodiment of the disclosure, the plurality of second microcavities of the light source module are respectively arranged along a plurality of virtual planes parallel to the light-emitting surface. The plurality of virtual planes are spaced apart along a normal direction of the light-emitting surface. The number of the plurality of second microcavities arranged on each of the plurality of virtual planes is the same.

In an embodiment of the disclosure, the plurality of second microcavities of the light source module include a first one, a second one and a third one arranged along each of the plurality of virtual planes. The first one and the second one are arranged adjacently with a first spacing along the direction. The second one and the third one are arranged adjacently with a second spacing along the direction. The first spacing is different from the second spacing.

In an embodiment of the disclosure, the plurality of second microcavities of the light source module are respectively arranged along a plurality of virtual planes parallel to the light-emitting surface. The plurality of virtual planes are spaced apart along a normal direction of the light-emitting surface. The plurality of second microcavities include a first one disposed on one of the plurality of virtual planes and a second one disposed on another of the plurality of virtual planes. A structural shape of the first one is different from a structural shape of the second one.

In an embodiment of the disclosure, the one of the plurality of virtual planes of the light source module is located between the another of the plurality of virtual planes and the light-emitting device. The structural shape of the first one of the plurality of second microcavities includes a spherical shape, a conical shape, an ellipsoidal shape or a cubic shape. The structural shape of the second one of the plurality of second microcavities includes an asymmetric conical shape or an irregular shape.

In an embodiment of the disclosure, the plurality of second microcavities of the light source module are respectively arranged along a plurality of virtual planes parallel to the light-emitting surface. The plurality of virtual planes are spaced apart along a normal direction of the light-emitting surface. The plurality of second microcavities include a first one disposed on one of the plurality of virtual planes and a second one disposed on another of the plurality of virtual planes. The encapsulation layer has a first cavity surface defining the first one and a second cavity surface defining the second one. A surface roughness of the first cavity surface is different from a surface roughness of the second cavity surface.

In an embodiment of the disclosure, the plurality of second microcavities of the light source module are respectively arranged along a plurality of virtual planes parallel to the light-emitting surface. The plurality of virtual planes are spaced apart along a normal direction of the light-emitting surface. The plurality of second microcavities include a first one and a second one disposed on each of the plurality of virtual planes. The encapsulation layer has a first cavity surface defining the first one and a second cavity surface defining the second one. A surface roughness of the first cavity surface is different from a surface roughness of the second cavity surface.

In an embodiment of the disclosure, the encapsulation layer of the light source module further has a second surface facing away from the first surface. The plurality of microcavities further include a plurality of second microcavities. The plurality of second microcavities are disposed adjacent to the second surface and are spaced apart along a direction parallel to the second surface to form a refractive unit.

In an embodiment of the disclosure, the second surface of the encapsulation layer of the light source module is provided with a surface microstructure. The plurality of second microcavities are embedded in the surface microstructure, and are conformally arranged along a part of the second surface defining the surface microstructure.

In an embodiment of the disclosure, the light source module further includes a plurality of microparticles filled in the plurality of microcavities. A refractive index of the plurality of microparticles is different from a refractive index of the encapsulation layer.

Based on the above, in a light source module according to an embodiment of the disclosure, the encapsulation layer has a first surface directly covering the substrate surface of the circuit board. By arranging a plurality of microcavities within part of the encapsulation layer adjacent to the first surface, unexpected light emission caused by poor reflection of part of light on the first surface of the encapsulation layer may be effectively avoided.

To make the aforementioned more comprehensible, several embodiments accompanied with drawings are described in detail as follows.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic cross-sectional view of a light source module according to a first embodiment of the disclosure.
FIG. 2 is an enlarged schematic diagram of a partial region of the light source module of FIG. 1.
FIGS. 3A to 3H are schematic cross-sectional views of other modified embodiments of a reflective unit of FIG. 2.
FIG. 4 is an enlarged schematic diagram of a partial region of the light source module of FIG. 1.
FIGS. 5A to 5C are schematic cross-sectional views of other modified embodiments of a refractive unit of FIG. 4.
FIGS. 6A to 6D are schematic cross-sectional views of other modified embodiments of a refractive unit of FIG. 5B.
FIG. 7 is an enlarged schematic diagram of a partial region of the light source module of FIG. 1.
FIGS. 8A and 8B are schematic cross-sectional views of other modified embodiments of a refractive unit of FIG. 7.
FIG.9 is a schematic cross-sectional view of a light source module according to a second embodiment of the disclosure.
FIG. 10 is a schematic cross-sectional view of a light source module according to a third embodiment of the disclosure.
FIG. 11 is an enlarged schematic diagram of a partial region of the light source module of FIG. 10.
FIGS. 12A to 12C are schematic cross-sectional views of other modified embodiments of the light source module of FIG. 11.
FIG. 13 is a schematic cross-sectional view of a light source module according to a fourth embodiment of the disclosure.
FIG. 14 is a schematic cross-sectional view of a light source module according to a fifth embodiment of the disclosure.

### DESCRIPTION OF THE EMBODIMENTS

The aforementioned technical contents, features and effects of the present invention will be clearly presented in the following detailed description of a preferred embodiment with reference to the drawings. The directional terms used in the following embodiments, such as up, down, left, right, front, or rear, are for reference to the directions indicated in the accompanying drawings. Therefore, these directional terms are used for explanation purposes and not for limiting the scope of the invention.

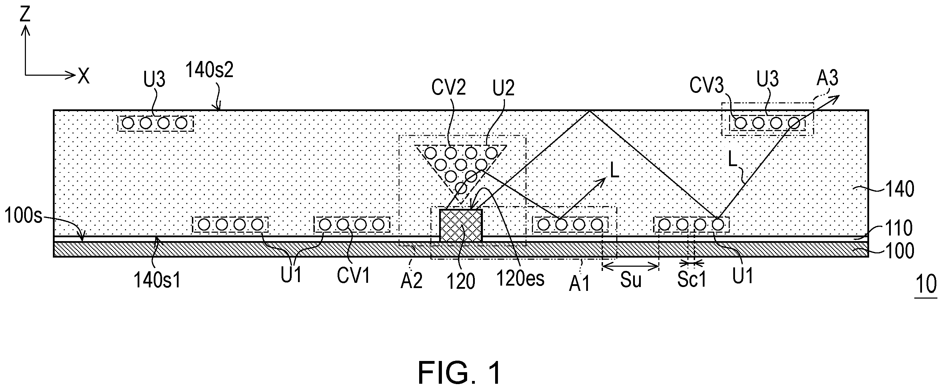

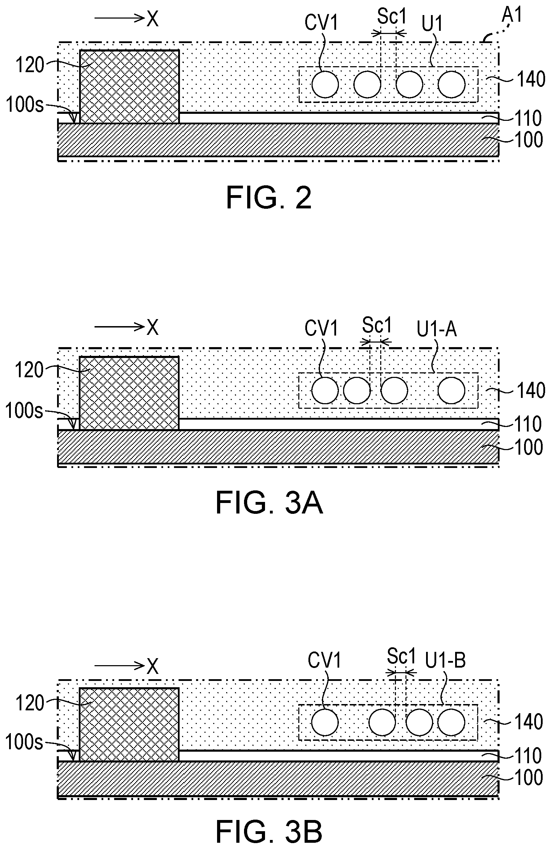

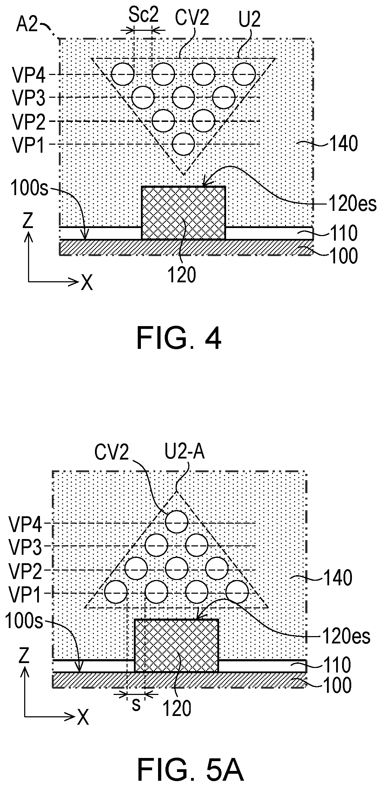

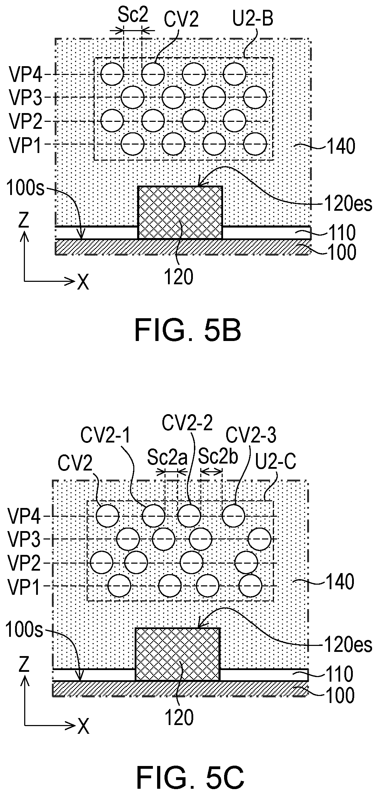

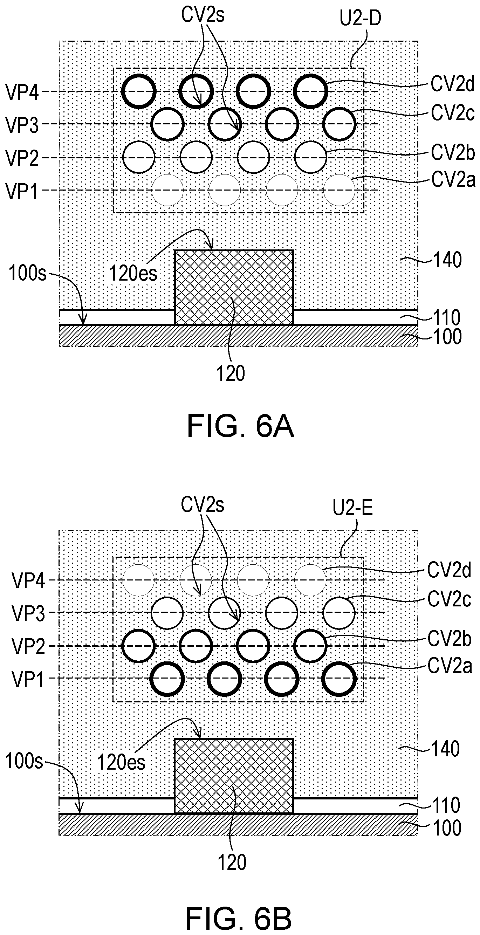

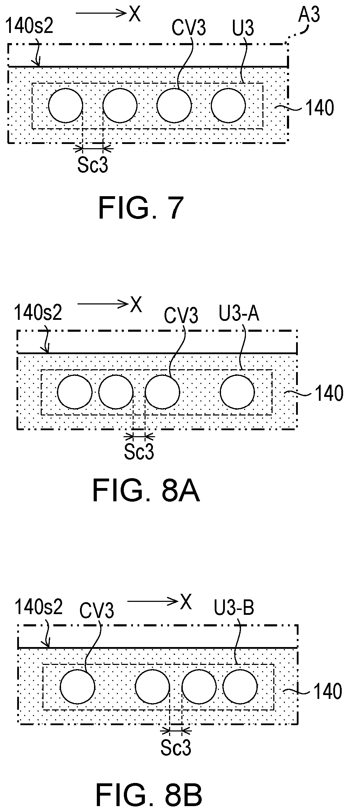

FIG. 1 is a schematic cross-sectional view of a light source module according to a first embodiment of the disclosure. FIG. 2 is an enlarged schematic diagram of a partial region of the light source module of FIG. 1. FIGS. 3A to 3H are schematic cross-sectional views of other modified embodiments of a reflective unit of FIG. 2. FIG. 4 is an enlarged schematic diagram of a partial region of the light source module of FIG. 1. FIGS. 5A to 5C are schematic cross-sectional views of other modified embodiments of a refractive unit of FIG. 4. FIGS. 6A to 6D are schematic cross-sectional views of other modified embodiments of a refractive unit of FIG. 5B. FIG. 7 is an enlarged schematic diagram of a partial region of the light source module of FIG. 1. FIGS. 8A and 8B are schematic cross-sectional views of other modified embodiments of a refractive unit of FIG. 7. FIG. 2 corresponds to the area A1 of FIG. 1. FIG. 4 corresponds to the area A2 of FIG. 1. FIG. 7 corresponds to the area A3 of FIG. 1.

Referring to FIG. 1 and FIG. 2, A light source module 10 includes a circuit board 100, a light-emitting device 120 and an encapsulation layer 140. The light-emitting device 120 is disposed on a substrate surface 100s of the circuit board 100, and is electrically connected to the circuit board 100. In the embodiment, the light-emitting device 120 may be a light-emitting diode (LED), such as mini-LED or micro-LED.

The encapsulation layer 140 directly covers the light-emitting device 120 and the substrate surface 100s of the circuit board 100, and has a first surface 140s1 and a second surface 140s2 facing away from each other. More specifically, the first surface 140s1 of the encapsulation layer 140 is connected to the substrate surface 100s of the circuit board 100. The material of the encapsulation layer 140 includes, for example, plastic, resin material (such as acrylic), or other suitable transparent encapsulation materials.

For example, in the embodiment, in order to prevent the circuit from being exposed to air and being oxidized by moisture or short-circuited by welding, the substrate surface 100s of the circuit board 100 may be provided with a solder resist ink layer 110 having moisture-proof, insulating, solder-proof and high-temperature resistance properties. In order to avoid unexpected light emission caused by the reflection of the solder resist ink layer 110 during the lateral transmission of part of light emitted by the light-emitting device 120 in the encapsulation layer 140, the light source module 10 further embeds a plurality of microcavities CV1 within a portion of the encapsulation layer 140 adjacent to the first surface 140s1. It is particularly important to note that the plurality of microcavities CV1 do not overlap with a light-emitting surface 120es of the light-emitting device 120 along a normal direction (e.g., direction Z) of the substrate surface 100s.

From another perspective, the plurality of microcavities CV1 are disposed on opposite sides of the light-emitting device 120 along any direction (e.g., direction X) parallel to the substrate surface 100s. For example, the plurality of microcavities CV1 may be spaced apart along any direction (e.g., direction X) parallel to the first surface 140s1 to form a plurality of reflective units U1, and a spacing Su between any two adjacent ones of the plurality of reflective units U1 along the any direction is greater than a spacing Sc1 between any two adjacent microcavities CV1 in any one of the plurality of reflective units U1 along the any direction.

However, the disclosure is not limited thereto. In another embodiment, the spacing Su between any two adjacent ones of the plurality of reflective units U1 may be equal to or approximately equal to the spacing Sc1 between any two adjacent microcavities CV1 in each reflective unit U1. In other words, the number and arrangement of the reflective units U1 near the first surface 140s1 may be adjusted according to the actual requirements of the light emission pattern. The present invention is not limited to the configurations disclosed in the drawings.

For example, part of light L emitted by the light-emitting device 120 is transmitted toward the circuit board 100 after total internal reflection through the second surface 140s2 of the encapsulation layer 140. Through the arrangement of the microcavity CV1 of the aforementioned reflective unit U1, the light L can undergo an additional total internal reflection on a cavity surface of the encapsulation layer 140 defining the microcavity CV1 and be directed toward the second surface 140s2 of the encapsulation layer 140 again. Such that, the probability that the light L emitted by the light-emitting device 120 is reflected or scattered by the substrate surface 100s of the circuit board 100 to produce unexpected light may be reduced, thereby improving the light-guiding efficiency of the encapsulation layer 140.

In the embodiment, the spacing Sc1 between any two adjacent microcavities CV1 in each reflective unit U1 along an arrangement direction (e.g., direction X) may be the same, but the disclosure is not limited thereto. In a modified embodiment not shown, the microcavities CV1 in the same reflective unit U1 can be arranged with an identical spacing Sc1, but the microcavities CV1 of different reflective units U1 can be arranged with different spacings Sc1. In other words, the arrangement spacing of the microcavities CV1 of the reflective unit U1 can be individually designed based on the position of the reflective unit U1.

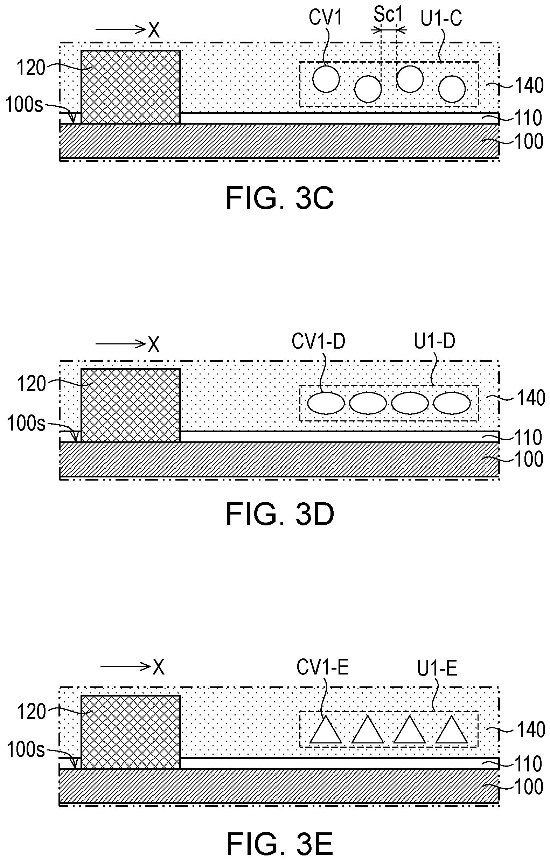

In a modified embodiment illustrated in FIG. 3A, the spacing Sc1 between any two adjacent microcavities CV1 in a reflective unit U1-A may increase as a distance from the light-emitting device 120 increases. If the cavity surface of the microcavity CV1 is smoother, the configuration of FIG. 3A can guide the light L toward a region farther from the light-emitting device 120. However, the disclosure is not limited thereto. In a modified embodiment illustrated in FIG. 3B, the spacing Sc1 between any two adjacent microcavities CV1 in a reflective unit U1-B may decrease as the distance from the light-emitting device 120 increases. Such that, the uniformity of the light L emitted from different regions of the encapsulation layer 140 may be improved. In a modified embodiment illustrated in FIG. 3C, any two adjacent microcavities CV1 in a reflective unit U1-C may be staggered from each other along the arrangement direction (e.g., direction X). It should be noted that the design of staggered arrangement shown in FIG. 3C may also be applied to the reflective unit in FIG. 3A or FIG. 3B.

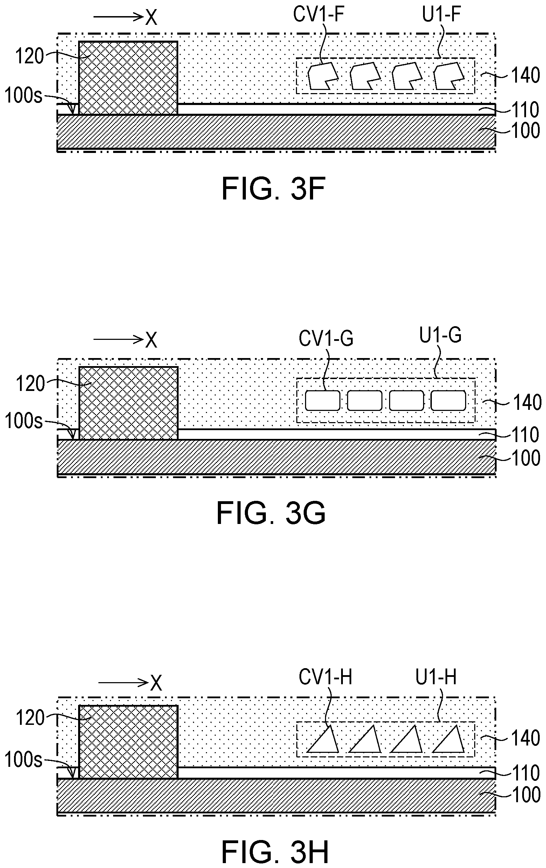

On the other hand, in the embodiment, a structural shape of the microcavity CV1 of the reflective unit U1 is, for example, a spherical shape (as shown in FIG. 2), but the disclosure is not limited thereto. In a modified embodiment illustrated in FIG. 3D, the structural shape of the microcavity CV1-D of the reflective unit U1-D may be an ellipsoidal shape. In a modified embodiment illustrated in FIG. 3E, the structural shape of the microcavity CV1-E of the reflective unit U1-E may be a conical shape. In a modified embodiment illustrated in FIG. 3F, the structural shape of the microcavity CV1-F of the reflective unit U1-F may be an irregular shape. In a modified embodiment illustrated in FIG. 3G, the structural shape of the microcavity CV1-G of the reflective unit U1-G may be a cubic shape. In a modified embodiment illustrated in FIG. 3H, the structural shape of the microcavity CV1-H of the reflective unit U1-H may be an asymmetric conical shape.

Referring to FIG. 1 and FIG. 4, to achieve a more uniform light emission effect on the second surface 140s2 of the encapsulation layer 140, the light source module 10 may further include a plurality of microcavities CV2 embedded in the encapsulation layer 140. The plurality of microcavities CV2 are disposed on one side of the light-emitting surface 120es of the light-emitting device 120, and overlap with the light-emitting surface 120es along the normal direction (e.g., direction Z) of the substrate surface 100s. In the embodiment, the structural shape of the microcavity CV2 may be a spherical shape, but the disclosure is not limited thereto. In other embodiments, the structural shape of the microcavity CV2 may include any structural shape of the microcavity shown in FIGS. 3C to 3H, such as the ellipsoidal shape (as shown in FIG. 3D), the conical shape (as shown in FIG. 3E), the irregular shape (shown in FIG. 3F), the cubic shape (as shown in FIG. 3G) or the asymmetric conical shape (as shown in FIG. 3H).

It is particularly important to note that the plurality of microcavities CV2 can be respectively arranged along a plurality of virtual planes VP1 to VP4 parallel to the light-emitting surface 120es to form a light modulating unit U2. In the embodiment, the virtual planes VP1 to VP4 may be arranged at equal intervals along the normal direction (e.g., direction Z) of the light-emitting surface 120es, but the disclosure is not limited thereto. For example, the number of the plurality of microcavities CV2 disposed on each virtual plane may increase as the distance from the light-emitting surface 120es increases. That is, the plurality of virtual planes VP1 to VP4 are sorted in ascending order based on the number of microcavities CV2 they each have, as follows: the virtual plane VP1, the virtual plane VP2, the virtual plane VP3 and the virtual plane VP4.

In the embodiment, any two adjacent ones of the plurality of microcavities CV2 arranged on the same virtual plane along any direction (e.g., direction X) parallel to the virtual plane have the same spacing Sc2, and two parts of the plurality of microcavities CV2 respectively arranged along any two adjacent ones of the plurality of virtual planes VP1 to VP4 are staggered from each other in the normal direction of the light-emitting surface 120es.

However, the disclosure is not limited thereto. In a modified embodiment illustrated in FIG. 5A, the number of microcavities CV2 of a light modulating unit U2-A disposed on each virtual plane may decrease as the distance from the light-emitting surface 120es increases. That is, the plurality of virtual planes VP1 to VP4 are arranged in ascending order based on the number of microcavities CV2 they each have, as follows: the virtual plane VP4, the virtual plane VP3, the virtual plane VP2 and the virtual plane VP1. In a modified embodiment illustrated in FIG. 5B, the number of microcavities CV2 of a light modulating unit U2-B on each virtual plane is the same.

In a modified embodiment illustrated in FIG. 5C, the arrangement spacings of the plurality of microcavities CV2 of a light modulating unit U2-C on the same virtual plane may be different. For example, the plurality of microcavities CV2 include a first one (e.g., microcavity CV2-1), a second one (e.g., microcavity CV2-2) and a third one (e.g., microcavity CV2-3) arranged along the virtual plane VP4. The first one and the second one are adjacently arranged along the arrangement direction (e.g., direction X) with a spacing Sc2a. The second one and the third one are adjacently arranged along the arrangement direction with a spacing Sc2b, and the spacing Sc2a is different from the spacing Sc2b. Since the arrangement of the microcavities CV2 on the virtual planes VP1, VP2 and VP3 is similar to the arrangement on the virtual plane VP4, details will not be repeated herein.

FIGS. 6A to 6D respectively illustrate some modified embodiments in which the arrangement and distribution of the plurality of microcavities are similar to FIG. 5B. The difference is that the cavity surface of each of the plurality of microcavities may have different surface roughness in light modulating units of FIGS. 6A to 6D. In the light modulating units of FIGS. 6A to 6C, the surface roughness of the cavity surface CV2s of the encapsulation layer 140 defining the microcavity varies depending on the distance between the virtual plane where the microcavity is located and the light-emitting surface 120es.

For example, in a light modulating unit U2-D of FIG. 6A, the surface roughness of the cavity surface CV2s of the microcavity increases as the distance between the virtual plane where the microcavity is located and the light-emitting surface 120es increases. In detail, the plurality of microcavities constituting the light modulating unit U2-D include a first one (i.e., the microcavity CV2a) arranged on the virtual plane VP1, a second one (i.e., the microcavity CV2b) arranged on the virtual plane VP2, a third one (i.e., the microcavity CV2c) arranged on the virtual plane VP3, and a fourth one (i.e., the microcavity CV2d) arranged on the virtual plane VP4. The plurality of microcavities CV2a to CV2d are sorted in ascending order based on the roughness of the cavity surface CV2s as follows: the microcavity CV2a, the microcavity CV2b, the microcavity CV2c and the microcavity CV2d.

On the contrary, in a light modulating unit U2-E of FIG. 6B, the surface roughness of the cavity surface CV2s of the microcavity decreases as the distance between the virtual plane where the microcavity is located and the light-emitting surface 120es increases. That is, the plurality of microcavities CV2a to CV2d are sorted in ascending order based on the roughness of the cavity surface CV2s as follows: the microcavity CV2d, the microcavity CV2c, the microcavity CV2b and the microcavity CV2a.

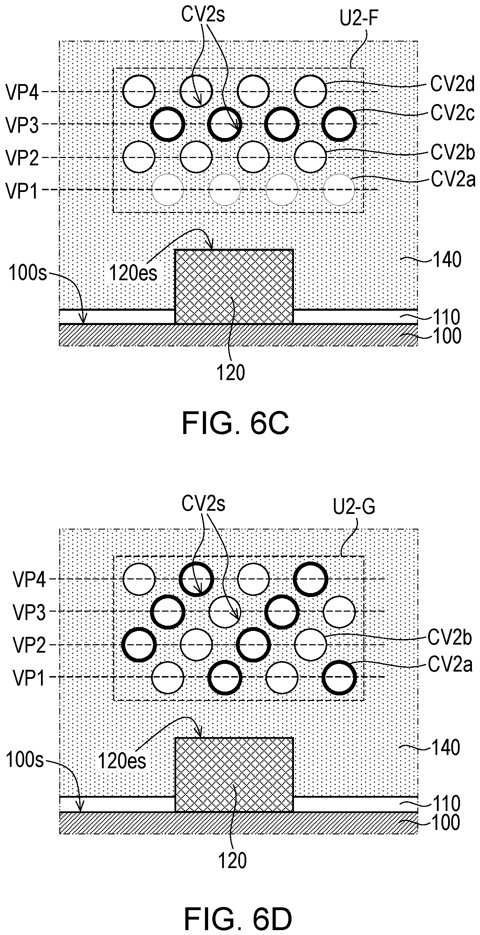

In a light modulating unit U2-F of FIG. 6C, the surface roughness of the cavity surface CV2s of the microcavity first increases and then decreases as the distance between the virtual plane where the microcavity is located and the light-emitting surface 120es increases. For example, the plurality of microcavities CV2a to CV2d are sorted in ascending order based on the roughness of the cavity surface CV2s as follows: the microcavity CV2a, the microcavity CV2b, the microcavity CV2d and the microcavity CV2c.

Different from the light modulating units of FIGS. 6A to 6C, in a light modulating unit U2-G of FIG. 6D, the plurality of microcavities arranged on the same virtual plane may have cavity surfaces with different surface roughness. For example, the plurality of microcavities include a first one (e.g., the microcavity CV2a), a second one (e.g., the microcavity CV2b) arranged on each virtual plane. The surface roughness of the cavity surface CV2s of the encapsulation layer 140 defining the first one may be different from (e.g., greater than) the surface roughness of the cavity surface CV2s of the encapsulation layer 140 defining the second one. In another modified embodiment, according to different requirements of light pattern, the surface roughness of the cavity surface CV2s of each of the plurality of microcavities arranged on the same virtual plane may be classified into three or more types.

Through the aforementioned configurations of various microcavities, the adjustment of capabilities of the light modulating unit for deflection, reflection and scattering of light becomes more flexible and diverse, which helps to meet the different light emission requirements of the light source module.

Referring to FIG. 1 and FIG. 7, on the other hand, the light source module 10 further embeds a plurality of microcavities CV3 within a portion of the encapsulation layer 140 adjacent to the second surface 140s2. The microcavities CV3 are spaced apart along any direction (e.g., direction X) parallel to the second surface 140s2 to form a plurality of refractive units U3. The refractive unit U3 is suitable for directing light L at a specific angle to meet different light emission requirements. In the embodiment, the plurality of microcavities CV3 constituting the refractive unit U3 may be arranged along an arrangement direction (e.g., direction X) with the same spacing Sc3, but the disclosure is not limited thereto. In a modified embodiment of FIG. 8A, the spacing Sc3 between any two adjacent ones of the plurality of microcavities CV3 constituting a refractive unit U3-A may increase as the distance from the light-emitting device 120 increases. In a modified embodiment of FIG. 8B, the spacing Sc3 between any two adjacent ones of the plurality of microcavities CV3 constituting a refractive unit U3-B may decrease as the distance from the light-emitting device 120 increases.

In the embodiment, the structural shape of the microcavity CV3 may be a spherical shape, but the disclosure is not limited thereto. In other embodiments, the structural shape of the microcavity CV3 may include any one of the structural shapes of the microcavity illustrated in FIGS. 3C to 3H, such as an ellipsoidal shape (as shown in FIG. 3D), a conical shape (as shown in FIG. 3E), an irregular shape (as shown in FIG. 3F), a cubic shape (as shown in FIG. 3G) or an asymmetric conical shape (as shown in FIG. 3H).

It is particularly noted that the microcavities constituting the reflective unit U1, the light modulating unit U2 or the refractive unit U3 may be fabricated using the process technology of laser sintering encapsulation materials. The encapsulation materials include, for example, silicone, but the disclosure is not limited thereto. Preferably, the size of the aforementioned microcavity in any direction may be greater than or equal to 10 microns and less than or equal to 100 microns.

Some other embodiments are provided below to describe the invention in detail, where the same reference numerals denote the same or like components, and descriptions of the same technical contents are omitted. The aforementioned embodiment may be referred for descriptions of the omitted parts, and detailed descriptions thereof are not repeated in the following embodiment.

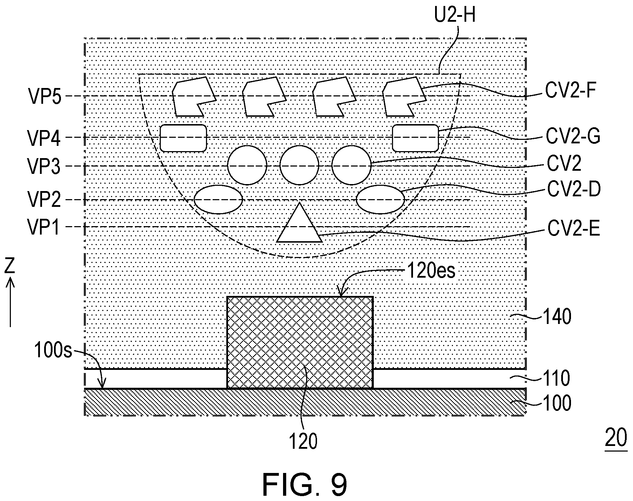

FIG.9 is a schematic cross-sectional view of a light source module according to a second embodiment of the disclosure. Referring to FIG. 9, the difference between a light source module 20 of the embodiment and the light source module 10 of FIGS. 1 and 4 lies in that the composition and configuration of the light modulating unit are different. Specifically, in the light source module 20 of the embodiment, the structural shape of the microcavities of the light modulating unit U2-H on each virtual plane are different from each other.

For example, the light modulating unit U2-H is provided with a microcavity CV2-E, a microcavity CV2-D, a microcavity CV2, a microcavity CV2-G and a microcavity CV2-F on the virtual plane VP1, the virtual plane VP2, the virtual plane VP3, the virtual plane VP4, and the virtual plane VP5 respectively. The structural shape of the microcavity CV2-E is a conical shape, the structural shape of the microcavity CV2-D is an ellipsoidal shape, the structural shape of the microcavity CV2 is a spherical shape, the structural shape of the microcavity CV2-G is a cubic shape, and the structural shape of the microcavity CV2-F is an irregular shape, but the disclosure is not limited thereto.

In particular, the plurality of microcavities CV2-F arranged on the virtual plane VP5 farthest from the light-emitting device 120 are suitable for scattering light to achieve a diffused or frosted light effect, and the microcavities CV2-E, the microcavity CV2-D, the microcavity CV2 and the microcavity CV2-G arranged between the virtual plane VP5 and the light-emitting device 120 are suitable for refracting or reflecting light to achieve functional and precise deflection effects.

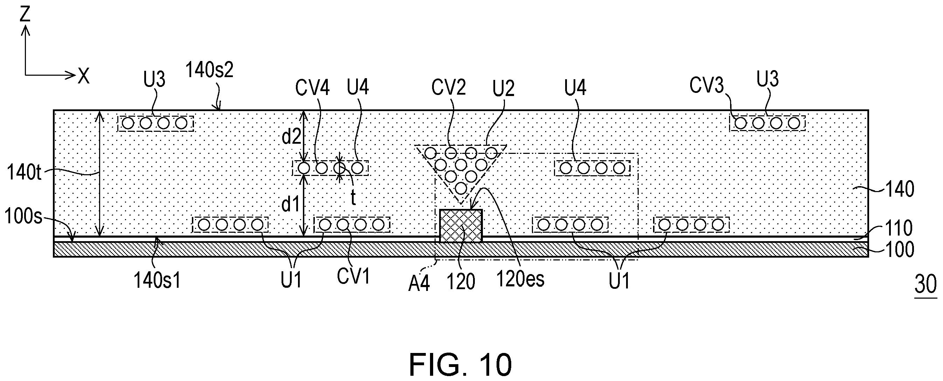

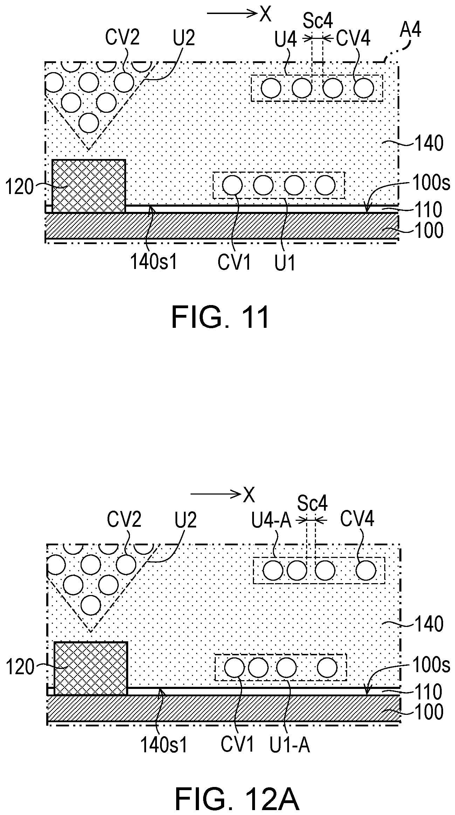

FIG. 10 is a schematic cross-sectional view of a light source module according to a third embodiment of the disclosure. FIG. 11 is an enlarged schematic diagram of a partial region of the light source module of FIG. 10. FIGS. 12A to 12C are schematic cross-sectional views of other modified embodiments of the light source module of FIG. 11. Referring to FIG. 10 and FIG. 11, the difference between a light source module 30 of the embodiment and the light source module 10 of FIG. 1 lies in that the light source module 30 further includes a plurality of microcavities CV4 disposed on one side of the plurality of microcavities CV1 facing away from the first surface 140s1. The plurality of microcavities CV4 are spaced apart along a direction (e.g., direction X) parallel to the first surface 140s1 to form a refractive unit U4.

It is particularly noted that the refractive unit U4 partially overlaps the reflective unit U1 in the normal direction of the substrate surface 100s, and the refractive unit U4 and the reflective unit U1 are staggered from each other. A distance d1 between the refractive unit U4 and the first surface 140s1 and a distance d2 between the refractive unit U4 and the second surface 140s2 are greater than or equal to a thickness t of one refractive unit U4. Preferably, the encapsulation layer 140 has a thickness 140t along the normal direction of the substrate surface 100s, and a ratio of each of the distance d1 and the distance d2 to the thickness 140t falls within a range of 0.5 to 0.95. That is, the refractive unit U4 is embedded in a portion of the encapsulation layer 140 farther from both the first surface 140s1 and the second surface 140s2. Through the configuration of the refractive unit U4, the defect concealing effect of the encapsulation layer 140 may be improved.

In the embodiment, a spacing Sc4 of any two adjacent microcavities CV4 in each refractive unit U4 arranged along a direction parallel to the first surface 140s1 (e.g., direction X) may be the same, but the disclosure is not limited thereto. In a modified embodiment not shown, the microcavities CV4 of the same refractive unit U4 may be arranged with the same spacing Sc4, but the microcavities CV4 of different refractive units U4 may be arranged with different spacings Sc4. In other words, the arrangement spacing of the microcavities CV4 of the refractive unit U4 can be individually designed based on the position of the refractive unit U4.

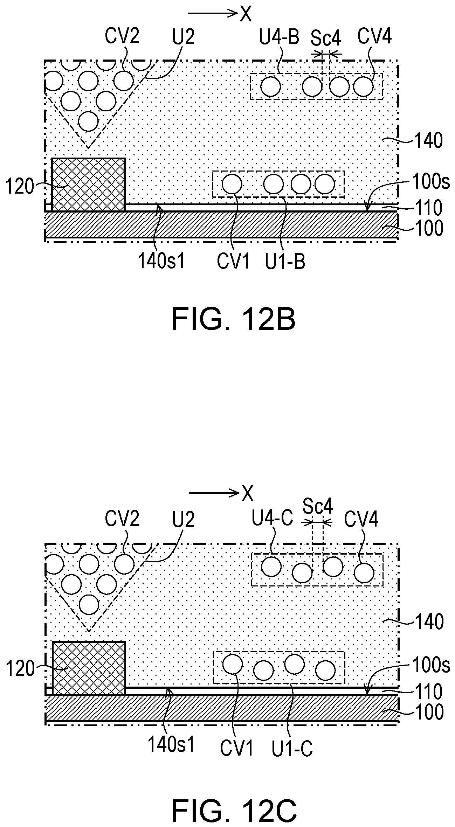

In a modified embodiment illustrated in FIG. 12A, the spacing Sc4 between any two adjacent microcavities CV4 in a refractive unit U4-A may increase as the distance from the light-emitting device 120 increases. However, the disclosure is not limited thereto. In a modified embodiment illustrated in FIG. 12B, the spacing Sc4 between any two adjacent microcavities CV4 in a refractive unit U4-B may decrease as the distance from the light-emitting device 120 increases. In a modified embodiment illustrated in FIG. 12C, any two adjacent microcavities CV4 in a refractive unit U4-C may be staggered from each other along the arrangement direction (e.g., direction X). It should be noted that the design of staggered arrangement shown in FIG. 12C may also be applied to the refractive unit in FIG. 12A or FIG. 12B.

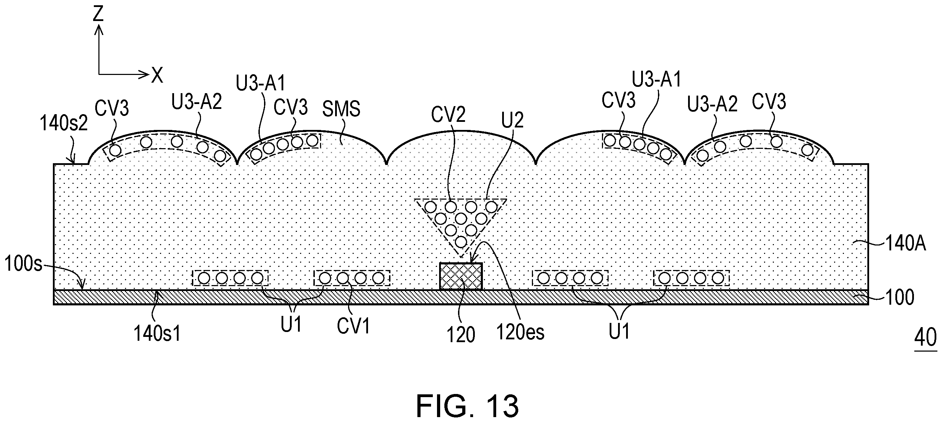

FIG. 13 is a schematic cross-sectional view of a light source module according to a fourth embodiment of the disclosure. Referring to FIG. 13, the main difference between a light source module 40 of the embodiment and the light source module 10 of FIG. 1 lies in that the configuration of the second surface of the encapsulation layer is different. Specifically, in the light source module 40 of the embodiment, the second surface 140s2 of the encapsulation layer 140A may be provided with a plurality of surface microstructures SMS. The surface microstructure SMS is, for example, a protruding structure protruding from the second surface 140s2, but the disclosure is not limited thereto. In other embodiments, the surface microstructure SMS may be a recessed structure recessed from the second surface 140s2 toward the interior of the encapsulation layer 140A. On the other hand, in the embodiment, the substrate surface 100s of the circuit board 100 is not covered with the solder resist ink layer 110 as shown in FIG. 1, and the encapsulation layer 140A directly covers the circuit layer (not shown) on the circuit board 100.

In the embodiment, the surface microstructure SMS is, for example, a microlens structure, but the disclosure is not limited thereto. In other embodiments, the structural type of the surface microstructure SMS may include a bump structure, a groove structure, or other suitable protruding structures or recessed structures, or combinations thereof.

It is important to note that, in the embodiment, the plurality of microcavities CV3 disposed adjacent to the second surface 140s2 are embedded in the plurality of surface microstructures SMS, and conformally arranged along a part of the second surface 140s2 defining the surface microstructure SMS. The microcavities CV3 may be arranged into a plurality of refractive units U3-A1 and a plurality of refractive units U3-A2, and the refractive units embedded in different surface microstructures SMS may have different arrangements. For example, the plurality of microcavities CV3 of the refractive unit U3-A1 embedded in the surface microstructure SMS closer to the light-emitting device 120 are arranged in a substantially equidistant manner. However, the arrangement spacing of the plurality of microcavities CV3 of the refractive unit U3-A2 embedded in the surface microstructure SMS farther from the light-emitting device 120 increases as the distance from the light-emitting device 120 increases. However, the disclosure is not limited thereto. In other embodiments, the arrangement of the plurality of microcavities in the refractive unit may be adjusted according to actual requirements of light emission.

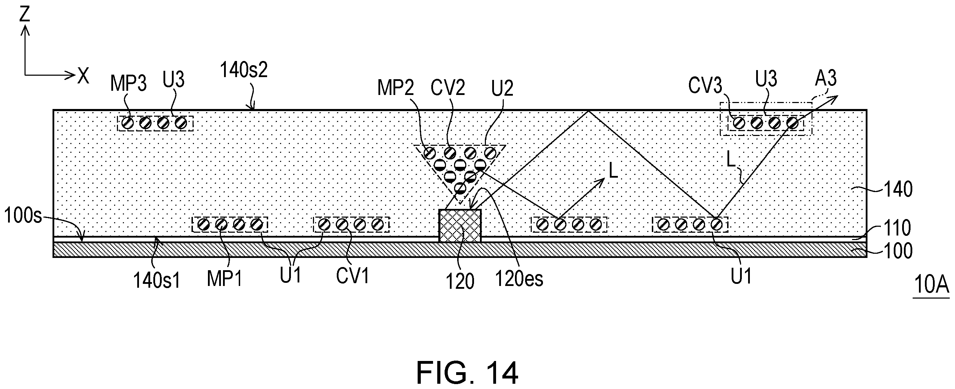

FIG. 14 is a schematic cross-sectional view of a light source module according to a fifth embodiment of the disclosure. Referring to FIG. 14, the difference between a light source module 10A of the embodiment and the light source module 10 of FIG. 1 lies in that the light source module 10A of the embodiment may further include a plurality of microparticles disposed in the plurality of microcavities, and a refractive index of the microparticles is different from a refractive index of the encapsulation layer.

For example, in the embodiment, the microcavity CV1 of the reflective unit U1 may be filled with microparticles MP1, the microcavity CV2 of the light modulating unit U2 may be filled with microparticles MP2, and the microcavity CV3 of the refractive unit U3 may be filled with microparticles MP3. In the embodiment, the refractive indices of the microparticles MP1, MP2 and MP3 may be substantially the same, but the disclosure is not limited thereto. In other embodiments, the refractive indices of the microparticles MP1, MP2 and MP3 may be different from each other. In some embodiments, the plurality of microparticles in the same reflective unit U1, light modulating unit U2 or refractive unit U3 may have different refractive indices.

Specifically, in some embodiments, the microparticles may have a gradient refractive index distribution within the microcavity, but the disclosure is not limited thereto. In other embodiments, the microparticles may have a uniform refractive index distribution within the microcavity.

To sum up, in a light source module according to an embodiment of the disclosure, the encapsulation layer has a first surface directly covering the substrate surface of the circuit board. By arranging a plurality of microcavities within part of the encapsulation layer adjacent to the first surface, unexpected light emission caused by poor reflection of part of light on the first surface of the encapsulation layer may be effectively avoided.

## Claims

1. A light source module (10, 10A, 20, 30, 40), comprising:
a circuit board (100);
a light-emitting device (120), disposed on a substrate surface (100s) of the circuit board (100), and electrically connected to the circuit board (100);
an encapsulation layer (140, 140A), directly covering the substrate surface (100s) and the light-emitting device (120), and having a first surface (140s1) connected to the substrate surface (100s); and
a plurality of microcavities (100), embedded in the encapsulation layer, wherein at least a part (CV1, CV1-D, CV1-E, CV1-F, CV1-G, CV1-H) of the plurality of microcavities (CV1, CV2, CV1-D, CV1-E, CV1-F, CV1-G, CV1-H, CV2-1, CV2-2, CV2-3, CV2a, CV2b, CV2c, CV2d, CV2-D, CV2-E, CV2-F, CV2-G, CV3, CV4) are disposed adjacent to the first surface (140s1) and do not overlap with a light-emitting surface (140es) of the light-emitting device (120) along a normal direction (Z) of the substrate surface (100s).

2. The light source module (10, 10A, 20, 30, 40) according to claim 1, wherein the at least a part of the plurality of microcavities (CV1, CV2, CV1-D, CV1-E, CV1-F, CV1-G, CV1-H, CV2-1, CV2-2, CV2-3, CV2a, CV2b, CV2c, CV2d, CV2-D, CV2-E, CV2-F, CV2-G, CV3, CV4) include a plurality of first microcavities (CV1, CV1-D, CV1-E, CV1-F, CV1-G, CV1-H), the plurality of first microcavities (CV1, CV1-D, CV1-E, CV1-F, CV1-G, CV1-H) are disposed adjacent to the first surface (140s1) and are spaced apart along a direction (X) parallel to the first surface (140s1) to form a reflective unit (U1, U1-A, U1-B, U1-C, U1-D, U1-E, U1-F, U1-G, U1-H), a plurality of the reflective units (U1, U1-A, U1-B, U1-C, U1-D, U1-E, U1-F, U1-G, U1-H) are spaced apart along the direction (X), and a spacing (Su) between any two adjacent ones of the plurality of reflective units (U1, U1-A, U1-B, U1-C, U1-D, U1-E, U1-F, U1-G, U1-H) along the direction (X) is greater than a spacing (Sc1) between any two adjacent ones of the plurality of first microcavities (CV1, CV1-D, CV1-E, CV1-F, CV1-G, CV1-H) along the direction (X).

3. The light source module (10, 10A, 20, 30, 40) according to claim 2, wherein the spacing (Sc1) between any two adjacent ones of the plurality of first microcavities (CV1) decreases or increases as a distance from the light-emitting device (120) increases.

4. The light source module (10, 10A, 20, 30, 40) according to claim 2, wherein any two adjacent ones of the plurality of first microcavities (CV1) are staggered from each other along the direction (X).

5. The light source module (30) according to claim 2, wherein the plurality of microcavities (CV1, CV2, CV3, CV4) further include a plurality of second microcavities (CV4), disposed on one side of the plurality of first microcavities (CV1) facing away from the first surface (140s1) and spaced apart along the direction (X) to form a refractive unit (U4, U4-A, U4-B, U4-C), and in the normal direction (Z) of the substrate surface (100s), a distance (d1, d2) between the refractive unit (U4, U4-A, U4-B, U4-C) and the first surface (140s1) or a second surface (140s2) is greater than or equal to a thickness (t) of the refractive unit (U4, U4-A, U4-B, U4-C).

6. The light source module (30) according to claim 5, wherein a spacing (Sc4) between any two adjacent ones of the plurality of second microcavities (CV4) decreases or increases as a distance from the light-emitting device (120) increases.

7. The light source module (30) according to claim 5, wherein any two adjacent ones of the plurality of second microcavities (CV4) are staggered from each other along the direction (X).

8. The light source module (30) according to claim 5, wherein in the normal direction (Z) of the substrate surface (100s), the refractive unit (U4, U4-A, U4-B, U4-C) partially overlaps the reflective unit (U1, U1-A, U1-B, U1-C), and the refractive unit (U4, U4-A, U4-B, U4-C) and the reflective unit (U1, U1-A, U1-B, U1-C) are staggered from each other.

9. The light source module (10, 10A, 20, 30, 40) according to claim 2, wherein the plurality of microcavities (CV1, CV2, CV1-D, CV1-E, CV1-F, CV1-G, CV1-H, CV2-1, CV2-2, CV2-3, CV2a, CV2b, CV2c, CV2d, CV2-D, CV2-E, CV2-F, CV2-G, CV3, CV4) further include a plurality of second microcavities (CV2, CV2-1, CV2-2, CV2-3, CV2a, CV2b, CV2c, CV2d, CV2-D, CV2-E, CV2-F, CV2-G), disposed on one side of the light-emitting surface (120es) of the light-emitting device (120), and in the normal direction (Z) of the substrate surface (100s), a light modulating unit (U2, U2-A, U2-B, U2-C, U2-D, U2-E, U2-F, U2-G, U2-H) composed of the plurality of second microcavities (CV2, CV2-1, CV2-2, CV2-3, CV2a, CV2b, CV2c, CV2d, CV2-D, CV2-E, CV2-F, CV2-G) overlaps the light-emitting surface (120es).

10. The light source module (10, 10A, 30, 40) according to claim 9, wherein the plurality of second microcavities (CV2) are respectively arranged along a plurality of virtual planes (VP1, VP2, VP3, VP4) parallel to the light-emitting surface (120es), the plurality of virtual planes (VP1, VP2, VP3, VP4) are spaced apart along a normal direction (Z) of the light-emitting surface (120es), and the number of the plurality of second microcavities (CV2) arranged on each of the plurality of virtual planes (VP1, VP2, VP3, VP4) increases or decreases as a distance from the light-emitting surface (120es) increases.

11. The light source module (10, 10A, 30, 40) according to claim 10, wherein two parts of the plurality of second microcavities (CV2) respectively arranged along any two adjacent ones of the plurality of virtual planes (VP1, VP2, VP3, VP4) are staggered from each other in the normal direction (Z) of the light-emitting surface (120es).

12. The light source module (10, 10A, 30, 40) according to claim 9, wherein the plurality of second microcavities (CV2, CV2-1, CV2-2, CV2-3, CV2a, CV2b, CV2c, CV2d) are respectively arranged along a plurality of virtual planes (VP1, VP2, VP3, VP4) parallel to the light-emitting surface (120es), the plurality of virtual planes (VP1, VP2, VP3, VP4) are spaced apart along a normal direction (Z) of the light-emitting surface (120es), and the number of the plurality of second microcavities (CV2, CV2-1, CV2-2, CV2-3, CV2a, CV2b, CV2c, CV2d) arranged on each of the plurality of virtual planes (VP1, VP2, VP3, VP4) is the same.

13. The light source module (10, 10A, 30, 40) according to claim 12, wherein the plurality of second microcavities (CV2, CV2-1, CV2-2, CV2-3, CV2a, CV2b, CV2c, CV2d) include a first one (CV2-1), a second one (CV2-2) and a third one (CV2-3) arranged along each of the plurality of virtual planes (VP1, VP2, VP3, VP4), the first one (CV2-1) and the second one (CV2-2) are arranged adjacently with a first spacing (Sc2a) along the direction (X), the second one (CV2-2) and the third one (CV2-3) are arranged adjacently with a second spacing (Sc2b) along the direction (X), and the first spacing (Sc2a) is different from the second spacing (Sc2b).

14. The light source module (20) according to claim 9, wherein the plurality of second microcavities (CV2, CV2-D, CV2-E, CV2-F, CV2-G) are respectively arranged along a plurality of virtual planes (VP1, VP2, VP3, VP4) parallel to the light-emitting surface (120es), the plurality of virtual planes (VP1, VP2, VP3, VP4) are spaced apart along a normal direction (Z) of the light-emitting surface (120es), the plurality of second microcavities (CV2, CV2-D, CV2-E, CV2-F, CV2-G) include a first one disposed on one of the plurality of virtual planes (VP1, VP2, VP3, VP4) and a second one disposed on another of the plurality of virtual planes (VP1, VP2, VP3, VP4), and a structural shape of the first one is different from a structural shape of the second one.

15. The light source module (20) according to claim 14, wherein the one of the plurality of virtual planes (VP1, VP2, VP3, VP4) is located between the another of the plurality of virtual planes (VP1, VP2, VP3, VP4) and the light-emitting device (120), the structural shape of the first one (CV2, CV2-D, CV2-E, CV2-G) of the plurality of second microcavities (CV2, CV2-D, CV2-E, CV2-F, CV2-G) includes a spherical shape, a conical shape, an ellipsoidal shape or a cubic shape, and the structural shape of the second one (CV2-F) of the plurality of second microcavities (CV2, CV2-D, CV2-E, CV2-F, CV2-G) includes an asymmetric conical shape or an irregular shape.

16. The light source module (10, 10A, 30, 40) according to claim 9, wherein the plurality of second microcavities (CV2a, CV2b, CV2c, CV2d) are respectively arranged along a plurality of virtual planes (VP1, VP2, VP3, VP4) parallel to the light-emitting surface (120es), the plurality of virtual planes (VP1, VP2, VP3, VP4) are spaced apart along a normal direction (Z) of the light-emitting surface (120es), the plurality of second microcavities (CV2a, CV2b, CV2c, CV2d) include a first one disposed on one of the plurality of virtual planes (VP1, VP2, VP3, VP4) and a second one disposed on another of the plurality of virtual planes (VP1, VP2, VP3, VP4), the encapsulation layer (140) has a first cavity surface (CV2s) defining the first one and a second cavity surface (CV2s) defining the second one, and a surface roughness of the first cavity surface (CV2s) is different from a surface roughness of the second cavity surface (CV2s).

17. The light source module (10, 10A, 30, 40) according to claim 9, wherein the plurality of second microcavities (CV2a, CV2b) are respectively arranged along a plurality of virtual planes (VP1, VP2, VP3, VP4) parallel to the light-emitting surface (120es), the plurality of virtual planes (VP1, VP2, VP3, VP4) are spaced apart along a normal direction (Z) of the light-emitting surface (120es), the plurality of second microcavities (CV2a, CV2b) include a first one and a second one disposed on each of the plurality of virtual planes (VP1, VP2, VP3, VP4), the encapsulation layer (140) has a first cavity surface (CV2s) defining the first one and a second cavity surface (CV2s) defining the second one, and a surface roughness of the first cavity surface (CV2s) is different from a surface roughness of the second cavity surface (CV2s).

18. The light source module (10, 10A, 30, 40) according to claim 2, wherein the encapsulation layer (140) further has a second surface (140s2) facing away from the first surface (140s1), the plurality of microcavities (CV1, CV2, CV1-D, CV1-E, CV1-F, CV1-G, CV1-H, CV2-1, CV2-2, CV2-3, CV2a, CV2b, CV2c, CV2d, CV2-D, CV2-E, CV2-F, CV2-G, CV3, CV4) further include a plurality of second microcavities (CV3), the plurality of second microcavities (CV3) are disposed adjacent to the second surface (140s2) and are spaced apart along a direction (X) parallel to the second surface (140s2) to form a refractive unit (U3, U3-A, U3-A1, U3-A2, U3-B).

19. The light source module (40) according to claim 18, wherein the second surface (140s2) of the encapsulation layer (140A) is provided with a surface microstructure (SMS), the plurality of second microcavities (CV3) are embedded in the surface microstructure (SMS), and are conformally arranged along a part of the second surface (140s2) defining the surface microstructure (SMS).

20. The light source module (10A) according to claim 1, further comprising:
a plurality of microparticles (MP1, MP2, MP3), filled in the plurality of microcavities (CV1, CV2, CV1-D, CV1-E, CV1-F, CV1-G, CV1-H, CV2-1, CV2-2, CV2-3, CV2a, CV2b, CV2c, CV2d, CV2-D, CV2-E, CV2-F, CV2-G, CV3), wherein a refractive index of the plurality of microparticles (MP1, MP2, MP3) is different from a refractive index of the encapsulation layer (140).
